(19) Europäisches Patentamt
European Patent Office
Office européen des brevets

(11) Veröffentlichungsnummer: **0 010 225**
**B1**

(12) # EUROPÄISCHE PATENTSCHRIFT

(45) Veröffentlichungstag der Patentschrift: **25.11.81**

(51) Int. Cl.³: **G 03 C 1/70,** C 08 G 18/81, C 08 G 18/62

(21) Anmeldenummer: **79103776.5**

(22) Anmeldetag: **03.10.79**

(54) **Negativ arbeitende mit wässrigen Alkalilösungen entwickelbare lichtvernetzbare Schichten.**

(30) Priorität: **14.10.78 DE 2844902**

(43) Veröffentlichungstag der Anmeldung: **30.04.80 Patentblatt 80/9**

(45) Bekanntmachung des Hinweises auf die Patenterteilung: **25.11.81 Patentblatt 81/47**

(84) Benannte Vertragsstaaten: **BE CH DE FR GB IT**

(56) Entgegenhaltungen:
**DE-A-2 030 506**
**DE-A-2 111 415**
**US-A-2 728 745**
**US-A-3 655 625**
**FORTSCHRITTE CHEMISCHER FORSCHUNG, Band 13/2, 1969, Springer Verlag, Berlin, DE, J. L. R. WILLIAMS: »Photopolymerization and photocrossliniking of polymers«, Seiten 227—250**
**PRODUCT LICENSING INDEX, Nr. 84, April 1971, Hampshire, GB T. M. LAAKSO: »Alkali-soluble light sensitive polymers«, Seiten 49—52**

(73) Patentinhaber: **AGFA-GEVAERT Aktiengesellschaft, Patentabteilung, D-5090 Leverkusen 1 (DE)**

(72) Erfinder: **Lohse, Jürgen, Nicolai-Hartmann-Strasse 38, D-5090 Leverkusen (DE)**
Erfinder: **Helling, Günter, Dr., Martin-Luther-Strasse 5, D-5000 Koeln 40 (DE)**
Erfinder: **Resz, Raoul, Dr., Buchenkampsweg 10, D-5060 Bergisch-Gladbach 3 (DE)**
Erfinder: **Bartl, Herbert, Dr., Eichendorfweg 10, D-5068 Odenthal (DE)**

**EP 0 010 225 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

## Negativ arbeitende mit wäßrigen Alkalilösungen entwickelbare lichtvernetzbare Schichten

Die Erfindung betrifft lichtvernetzbare Schichten, die unter Lichteinwirkung filmbildende Cinnamoylgruppen enthaltende Polymere enthalten, die bei Belichtung unlöslich werden und mit einer wäßrig alkalischen Lösung entwickelt werden können.

Alkalilösliche lichtvernetzbare Polymere, auch Photolacke genannt, sind bekannt. Sie haben den Vorteil, daß sie mit nichttoxischen und nichtfeuergefährlichen Lösungsmitteln, d. h. mit Wasser oder wäßrig alkalischen Lösungen, entwickelt werden können.

Aus der US-A-2 861 058 ist ein lichtempfindliches Polymeres bekannt, das durch Veresterung von Polyvinylalkohol mit Zimtsäure und Bernsteinsäure erhalten wird. Die für eine ausreichende Löslichkeitsdifferenzierung notwendigerweise zur Entwicklung der belichteten Polymerschichten verwendete wäßrige Ammoniumhydroxydlösung hat jedoch eine Reihe von Nachteilen, beispielsweise einen stechenden Geruch, eine stark reizende Wirkung auf Augen und Schleimhäute und eine nur enge Entwicklungsbreite wegen ihrer Flüchtigkeit, durch die die Konzentration des Ammoniumhydroxyds in der Lösung herabgesetzt wird. Außerdem hat sich gezeigt, daß nach Aufbringen dieses Polymeren auf eine lithographische Druckplatte die Bildbereiche dieser Platte kein zufriedenstellendes Aufnahmevermögen für die Farbe haben. Die Polymeren weisen außerdem eine für ihre Verwendung als Photolack ungenügende Flexibilität auf. Dieses hat eine schlechte Haftung der Photolacke auf Metalloberflächen zur Folge, wodurch ein fehlerhaftes Klischee beim Ätzprozeß entsteht.

Aus der DE-A-2 124 047 ist eine lichtempfindliche Zusammensetzung bekannt, deren Alkalilöslichkeit durch phenolische Gruppen erreicht wird. Die phenolischen Gruppen aber erfordern erfahrungsgemäß recht konzentrierte alkalische Lösungen als Entwickler, die in der Regel zusätzlich noch Netzmittel enthalten. Außerdem sind auch die nach der Belichtung entstandenen vernetzten Bezirke solcher Photolackschichten nicht ausreichend elastisch und flexibel. Um aber in der Randzone der Photolackschicht eine Unterätzung zu verhindern bzw. zu hemmen ist eine gute Flexibilität und Elastizität des Beschichtungsmaterials unerläßlich, denn es ist erforderlich, daß sich das Beschichtungsmaterial um die bereits unterätzten Stellen legt und diese auch ohne feste Haftung an der Unterlage vor der Einwirkung des Ätzmittels schützt.

Die bisher bekannten alkalischen Photolackschichten besitzen durchweg eine zu hohe Brüchigkeit und Steifheit, um eine derartige Wirkung entfalten zu können. Sie sind nicht in der Lage, sich den veränderten Konturen der geätzten Platte anzupassen, und infolge ihrer Sprödigkeit neigen sie während des Entwicklungsprozesses, bei dem sie gleichzeitig einer mechanischen Beanspruchung unterworfen sind, dazu, an der Randzone abzubröckeln.

Cinnamoylgruppen enthaltende lichtvernetzbare Polymere sind aus der DE-A-2 111 415 bekannt. Diese Polymeren weisen zwar, bedingt durch die Struktur der Hauptkette, die aus verseiften Ethylen/Vinylester-Copolymerisaten besteht, die für Photolackschichten erwünschte Elastizität und Flexibilität auf, sie haben jedoch den Nachteil, daß sie in wäßrigen oder wäßrig alkalischen Entwicklungsbädern unlöslich sind und mit organischen Lösungsmitteln entwickelt werden müssen.

Lichtvernetzbare Polymere, die Cinnamoylgruppen enthalten und deren Schichten sich in wäßrigem Alkali entwickeln lassen, werden in der DE-B-1 080 403 beschrieben. Nachteilig an diesen Polymeren ist aber, daß die aus den Polymeren hergestellten Lackschichten zu brüchig sind. Die Sprödigkeit der Polymeren führt dazu, daß bei der Entwicklung bildmäßig belichteter Lackschichten bei kleinen Rasterpunkten Lackteile abbröckeln und somit die Qualität des erhaltenen Lackbildes beeinträchtigen.

Der vorliegenden Erfindung liegt die Aufgabe zugrunde, wäßrig alkalisch entwickelbare und gegen saure Ätzmittel ausreichend resistente lichtvernetzbare Schichten von hoher Lichtempfindlichkeit und guter Haftfestigkeit an verschiedenen Metalloberflächen zu entwickeln.

Die Aufgabe wird erfindungsgemäß gelöst mit einer lichtempfindlichen Schicht aus einem filmbildenden, unter Lichteinwirkung vernetzbaren, in wäßrig alkalischer Lösung entwickelbaren, Cinnamoylgruppen enthaltenden Polymeren, das dadurch gekennzeichnet ist, daß das Polymere der allgemeinen Formel

$$-(CH_2-CH_2)_u-(A)_v-$$

entspricht, in der

u 0 bis 70 Mol-%, vorzugsweise 30 bis 60 Mol-%,

v 30 bis 100 Mol-%, vorzugsweise 40 bis 70 Mol-% und

A 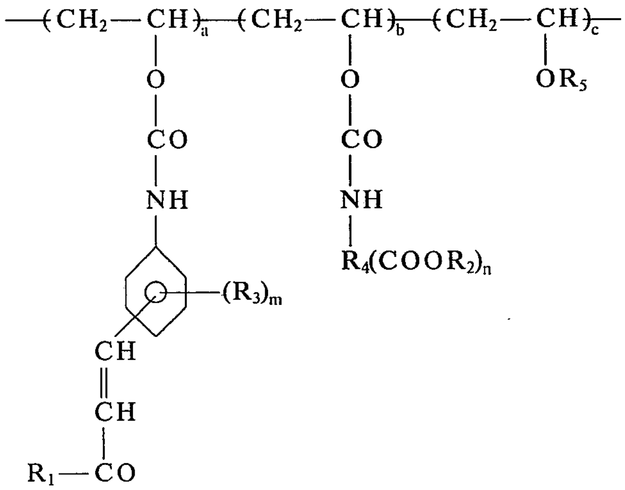

bedeuten und worin

$R_1$ Hydroxyl, Alkyl mit 1 bis 4 Kohlenstoffatomen, Aryl wie Phenyl und Naphthyl oder Alkoxy mit 1 bis 4 Kohlenstoffatomen, wobei die für $R_1$ enthaltenen Gruppen gleich oder verschieden sein können und der Anteil an Hydroxylgruppen mindestens 30 Mol-% beträgt,

$R_2$ ein Wasserstoffatom oder Alkyl mit 1 bis 4 Kohlenstoffatomen, wobei die für $R_2$ enthaltenen Reste gleich oder verschieden sein können und der Anteil an Wasserstoffatomen mindestens 30 Mol-% beträgt,

$R_3$ ein Halogenatom, eine $NO_2$-Gruppe, eine $CF_3$-Gruppe, Alkyl mit 1 bis 4 Kohlenstoffatomen oder Alkoxy mit 1 bis 4 Kohlenstoffatomen,

$R_4$ Alkylen mit 1 bis 6 Kohlenstoffatomen oder Arylen,

$R_5$ ein Wasserstoffatom, wenn $u > 0$ und ein Wasserstoffatom, eine $CH_3CO$-Gruppe oder eine $C_6H_5CO$-Gruppe, wenn $u = 0$

m 0 bis 3, vorzugsweise 0 bis 1

n 1 bis 3, vorzugsweise 1 oder 2

a 20 bis 100 Mol-%, vorzugsweise 50 bis 90 Mol-%

b 0 bis 50 Mol-%, vorzugsweise 5 bis 40 Mol-%

c 0 bis 30 Mol-%, vorzugsweise 5 bis 30 Mol-%

Die folgende Tabelle enthält Beispiele für Polymere, die als Photolack repräsentativ sind.

| Polymer | u | v | a | b | c | m | n |
|---|---|---|---|---|---|---|---|
| 1 | 58,7 | 41,3 | 75 | 25 | – | 0 | 1 |
| 2 | 55,1 | 44,9 | 68 | 25 | 7 | 0 | 2 |
| 3 | 55,1 | 44,9 | 68 | – | 32 | 0 | 1 |
| 4 | 55,1 | 44,9 | 92 | – | 8 | 0 | 1 |
| 5 | 55,1 | 44,9 | 68 | 24 | 8 | 0 | 1 |
| 6 | 58,7 | 41,3 | 68 | 25 | 7 | 0 | 1 |
| 7 | 58,7 | 41,3 | 68 | 25 | 7 | 0 | 1 |
| 8 | 0 | 100 | 58 | 0 | 42 | 0 | 1 |
| 9 | 55 | 45 | 70 | 24 | 6 | 1 | 1 |
| 10 | 55 | 45 | 68 | 25 | 7 | 2 | 1 |
| 11 | 55 | 45 | 72 | 20 | 8 | 1 | 1 |

Fortsetzung

| Polymer | u | v | a | b | c | m | n |
|---|---|---|---|---|---|---|---|
| 12 | 35 | 65 | 60 | 15 | 25 | 0 | 1 |
| 13 | 35 | 65 | 55 | 20 | 25 | 0 | 1 |
| 14 | 70 | 30 | 75 | 22 | 3 | 0 | 1 |
| 15 | 42 | 58 | 63 | 27 | 10 | 2 | 2 |
| 16 | 50 | 50 | 70 | 25 | 5 | 0 | 2 |
| 17 | 40 | 60 | 65 | 29 | 6 | 0 | 1 |
| 18 | 40 | 60 | 55 | 39 | 6 | 1 | 1 |
| 19 | 40 | 60 | 60 | 32 | 8 | 1 | 1 |
| 20 | 55 | 45 | 65 | 28 | 7 | 0 | 1 |
| 21 | 55 | 45 | 65 | 30 | 5 | 0 | 1 |
| 22 | 33 | 67 | 85 | 4 | 11 | 0 | 1 |
| 23 | 62 | 38 | 82 | 10 | 8 | 0 | 3 |
| 24 | 52 | 48 | 70 | 28 | 2 | 0 | 1 |
| 25 | 52 | 48 | 70 | 23 | 7 | 0 | 1 |
| 26 | 60 | 40 | 68 | 28 | 4 | 0 | 1 |
| 27 | 60 | 40 | 68 | 25 | 7 | 0 | 1 |
| 28 | 35 | 65 | 88 | 4 | 8 | 0 | 1 |
| 29 | 30 | 70 | 90 | 0 | 10 | 0 | 1 |
| 30 | 65 | 35 | 65 | 26 | 9 | 0 | 1 |
| 31 | 61 | 48 | 70 | 24 | 6 | 0 | 1 |

| $R_1$ | $R_2$ | Anteil H bzw. OH Lt. Säurezahlbestimmung (in Mol %) in $R_1$ bzw. $R_2$ | $R_3$ |
|---|---|---|---|
| OH, $OC_2H_5$ | H, $C_2H_5$ | 83% | – |
| OH, $OC_2H_5$ | H, $CH_3$ | 62% | – |
| OH, $OC_2H_5$ | H, $C_2H_5$ | 94% | – |
| OH, $OC_2H_5$ | H, $C_2H_5$ | 93% | – |
| OH, $OC_2H_5$ | H, $C_4H_9$ | 96% | – |
| OH, $OC_2H_5$ | H, $C_2H_5$ | 98% | – |
| OH, $OC_2H_5$ | H, $C_2H_5$ | 77% | – |
| OH, $OC_2H_5$ | | 97% | – |

Fortsetzung

| $R_1$ | $R_2$ | Anteil H bzw. OH Lt. Säurezahlbestimmung (in Mol %) in $R_1$ bzw. $R_2$ | $R_3$ |
|---|---|---|---|
| OH, $OiC_3H_7$ | H, $C_2H_5$ | 85% | –Cl |
| OH, $OCH_3$ | H, $C_2H_5$ | 78% | $-OCH_3$ |
| OH, $OCH_3$ | H, $C_2H_5$ | 92% | $-NO_2$ |
| OH, $OCH_3$ | H, $C_2H_5$ | 88% | – |
| OH, $OCH_3$ | H, $C_2H_5$ | 62% | – |
| OH, $OCH_3$ | H, $C_2H_5$ | 93% | – |
| OH, $OCH_3$ | H, $CH_3$ | 96% | $-CH_3$ |
| OH, $OCH_3$ | H, $C_2H_5$ | 83% | – |
| OH, $OCH_3$ | H, $C_2H_5$ | 84% | – |
| OH, $OCH_3$ | H, $CH_3$ | 58% | $-C_2H_5$ |
| OH, $OCH_3$ | H, $CH_3$ | 48% | $-OC_2H_5$ |
| OH, $OC_2H_5$ | H, $C_4H_9$ | 98% | – |
| OH, $OiC_3H_7$ | H, $C_2H_5$ | 74% | – |
| OH, $OC_3H_7$ | H, $C_2H_5$ | 45% | – |
| OH, $OC_4H_9$ | H, $C_2H_5$ | 72% | – |
| OH, $OC_2H_5$ | H, $C_3H_7$ | 97% | – |
| OH, $OC_2H_5$ | H, $iC_3H_7$ | 66% | – |
| OH, $OC_2H_5$ | H, $iC_3H_7$ | 86% | – |
| $C_2H_5$ | H, $CH_3$ | 93% | – |
| $C_2H_5$ | H, $CH_3$ | 92% | – |
| OH, $OC_2H_5$ | H, $CH_3$ | 36% | – |
| OH, $OC_2H_5$ | H, $CH_3$ | 89% | – |
| OH, $OC_2H_5$ | H, $CH_3$ | 85% | – |

| $R_3$ | $R_4$ | $R_5$ |
|---|---|---|
| – | Methylen | H |
| – | 1,3,5-Benzotriyl | H |
| – | Methylen | H |
| – | Methylen | H |

Fortsetzung

| $R_3$ | $R_4$ | $R_5$ |
|---|---|---|
| – | Äthylen | H |
| – | Methylen | H |
| – | p-Phenylen | H |
| – | – | $-CO-C_6H_5$, H**) |
| $-Cl$ | Methylen | H |
| $-OCH_3$ | Methylen | H |
| $-NO_2$ | Methylen | H |
| – | Trimethylen | H |
| – | Hexamethylen | H |
| – | Methylen | H |
| $-CH_3$ | 1,3,5-Benzatriyl | H |
| – | Phenylen | H |
| – | 1,4-Naphthylen | H |
| $-C_2H_5$ | Äthylen | H |
| $-OC_2H_5$ | Äthylen | H |
| – | Tetramethylen | H |
| – | Methylen | H |
| – | Methylen | H |
| – | 1,3,4,5-Benzotetrayl | H |
| – | p-Phenylen | H |
| – | o-Phenylen | H |
| – | Methylen | H |
| – | Methylen | H |
| – | Methylen | H |
| – | Methylen | H |
| – | Methylen | H |
| – | Methylen | H |

**) 15,4 Gew.-% H; 26,6 Gew.-% $-CO-C_6-H_5$

Charakteristisch für die erfindungsgemäß verwendeten lichtvernetzbaren Polymeren, im folgenden kurz Photolacke genannt, ist die Einführung von Carbalkoxygruppen in an sich bekannte, lichtempfindliche Cinnamoylgruppen enthaltenden Polymere und ihre in homogener Reaktion durchgeführte selektive Hydrolyse unter essentieller Erhaltung ihrer über Urethangruppen bewerkstelligten Verknüpfung zur jeweiligen Polymerkette. Die Urethangruppen entstehen bei der

Umsetzung von organischen Isocyanatderivaten mit den im Polymeren enthaltenen alkoholischen Hydroxylgruppen. Obwohl Unterschiede in der Verseifungsbeständigkeit von Carbonsäureester und Urethangruppen bekannt sind, war es überraschend, daß man dabei zu lichtvernetzbaren Polymeren gelangt, die neben einer für die Alkalilöslichkeit ausreichenden Menge Carboxygruppen auch die lichtempfindlichen Cinnamoylgruppen in genügender Anzahl enthalten, und daß diese Verbindungen eine für ihre Anwendung als Photolacke erforderliche Beständigkeit gegen die üblicherweise verwendeten Ätzmittel, wie z. B. verdünnte Salpetersäure oder Eisenchloridlösung, besitzen. Sie erfüllen ferner die zahlreichen an Photolacke gestellten, hohen, anwendungstechnischen Anforderungen hinsichtlich ihrer mechanischen Eigenschaften, Haftfestigkeit an verschiedenartigen metallischen Unterlagen, Lagerfähigkeit bei erhöhten Temperaturen u. dgl.

Als Ausgangsprodukte für die erfindungsgemäßen Kopierlacke können alle Hydroxylgruppen enthaltende Polymere, welche mindestens 15 Gewichtsprozent Hydroxylgruppen enthalten, verwendet werden, sofern sie in solchen Lösungsmitteln löslich sind, welche eine homogene Umsetzung mit organischen Isocyanatderivaten gestatten, d. h. mit diesem entweder gar nicht, oder wesentlich langsamer als die im Polymeren enthaltenen Hydroxylgruppen reagieren.

Als Hydroxylgruppen enthaltende Polymere können solche verwendet werden, die gegenüber organischen Isocyanatderivaten reaktive zu Urethangruppen umsetzbare Gruppen enthalten.

Die Polymerkette sollte dabei so beschaffen sein, daß sie während der üblicherweise nach der Belichtung und der Entwicklung durchgeführten Ätzung der beschichteten Metallteile keinen hydrolytischen Abbau erfährt.

Vorteilhafterweise werden Polyvinylalkohole bzw. Copolymerisate des Vinylalkohols mit Äthylen eingesetzt, die durch (Co-)Polymerisation von Vinylestern und anschließende Verseifung der (Co-)Polymeren erhalten werden. Von den verseiften Polymerisaten werden diejenigen bevorzugt, die aus 30 bis 100 Mol-% Vinylalkohol und 0 bis 70 Mol-% Äthylen, vorzugsweise aus 40 bis 70 Mol-% Vinylalkohol und 30 bis 60 Mol-% Äthylen, aufgebaut sind. Bei Verwendung von reinem Polyvinylalkohol geht man zweckmäßigerweise von teilweise acetylierten oder benzoylierten Polymeren aus, um anschließend die Reaktion mit den Isocyanaten in homogener Phase durchführen zu können.

Das Molekulargewicht der zur Herstellung der Photolacke eingesetzten Hydroxylgruppen enthaltenden Polymeren kann in weiten Grenzen, d. h. von ca. 5000 bis 100 000 variieren, der Molekulargewichtsbereich von ca. 10 000 bis 50 000 wird jedoch aus anwendungstechnischen Gründen bevorzugt. Niedermolekulare Photolacke besitzen in der Regel schlechte mechanische Eigenschaften, d. h. sie sind spröde und brüchig und zeigen außerdem eine zu niedrige Lichtempfindlichkeit, wogegen zu hochmolekulare Lacke schwer applizierbar und schlecht zu entwickeln sind. Die im Polymeren vorhandenen Hydroxylgruppen werden vollständig oder teilweise in die Urethangruppen enthaltenden Einheit a, oder a und b überführt.

Dabei soll der Anteil von a 20 Mol-% der ursprünglich vorhandenen Hydroxylgruppen nicht unterschreiten, um eine ausreichende Vernetzung der daraus hergestellten Schichten bei der Belichtung zu gewährleisten. Vorzugsweise werden mindestens 50 Mol-% der vorhandenen Hydroxylgruppen in die Einheit a überführt, damit eine gute Lichtempfindlichkeit der lichtvernetzbaren Schichten erreicht wird. Ist der Anteil a größer als 90%, zeigen die erfindungsgemäß verwendeten Photolacke eine geringere Lagerstabilität, so daß a vorzugsweise im Bereich von 50—90 Mol-% liegt. Der Anteil an c kann im Bereich von 0—70 Mol-% variieren. Bevorzugt ist der Bereich von 0—30 Mol-%. Ist der Anteil c größer als 30 Mol-%, so nimmt die Alkalilöslichkeit der Polymeren ab, insbesondere dann, wenn der Äthylenanteil u im Bereich von 50 bis 70 Mol-% liegt.

Der Anteil an b wird durch die gewählten Anteile an a und c festgelegt. Er dient dazu, die Alkalilöslichkeit der Photolacke zu verbessern. Als günstig hat sich ein Bereich von 5—40 Mol-% erwiesen.

Um eine gute Alkalilöslichkeit zu erreichen, soll ein hoher Anteil von $R_1$ und $R_2$ eine Hydroxylgruppe darstellen bzw. vervollständigen. Insbesondere dann, wenn das Polymere hohe Anteile u enthält, sollten mindestens 30 Mol-% der Reste $R_1$ oder $R_2$ oder $R_1$ und $R_2$ zusammen Hydroxylgruppen darstellen bzw. vervollständigen.

Die vorliegenden Polymeren besitzen die Zahl an seitenständigen Carboxylgruppen, die die gewünschte Alkalilöslichkeit garantieren. Die aus der DE-A-2 111 415 bekannten Polymeren, deren Seitenketten durch Umsetzung des die Hauptkette bildenden verseiften Ethylen/Vinylester-Copolymeren mit Cinnamoylgruppen enthaltenden Isocyanaten, die keine in wäßrigem Alkali hydrolysierbaren Gruppen aufweisen, gebildet werden, lassen sich nur in organischen Lösungsmitteln entwickeln und unterscheiden sich somit nachteilig von den Polymeren der Erfindung.

Die Herstellung der Photolacke kann nach beliebigen Methoden erfolgen, zweckmäßigerweise wird aber das Polymere nach den in den deutschen Patentschriften 1 063 802 und 1 067 219 und, beim Einsatz von verseiften Ethylen/Vinylestern, in der deutschen Offenlegungsschrift 2 111 415 beschriebenen Verfahren mit den Cinnamoylgruppen enthaltenden Isocyanatderivaten und gegebenenfalls mit weiteren Carbonsäureestergruppen enthaltenden Isocyanatderivaten umgesetzt und anschließend die Carbonsäureestergruppen durch Verseifung in freie Carboxygruppen überführt.

Die Herstellung der Cinnamoylgruppen und Carbonsäureestergruppen enthaltenden Isocyanate

kann in bekannter Weise durch Phosgenierung der entsprechenden Aminoverbindungen erfolgen, wie z. B. in Liebigs Annalen der Chemie, Band 562, Seite 75 (1949) beschrieben.

Die nach der Umsetzung mit Isocyanaten erfolgende selektive Hydrolyse der im Polymeren enthaltenen Carbonsäureestergruppen kann alkalisch oder sauer erfolgen. Vorzugsweise werden wäßrig-alkoholische Lösungen von starken Alkalimetall- oder Erdalkalimetallhydroxiden eingesetzt, insbesondere Natrium- oder Kaliumhydroxid. Die zu verwendende Menge an Alkalihydroxid wird durch den angestrebten Verseifungsgrad bestimmt. Zweckmäßigerweise werden mindestens 60 Gew.-% der vorhandenen Carbonsäureestergruppen verseift, um eine ausreichende Alkalilöslichkeit der Photolacke zu erzielen. Ein großer Überschuß an Alkalimetallhydroxid ist zu vermeiden, da in diesem Falle auch die vorhandenen Urethangruppen teilweise hydrolysiert werden können, was zu einer Verminderung der Lichtempfindlichkeit und der Alkalilöslichkeit des Photolacks führen kann.

Die Verseifung der mit Carbonsäureestergruppen enthaltenden Isocyanaten umgesetzten hydroxylgruppenhaltigen Polymeren wird zweckmäßigerweise ohne Isolierung direkt nach der Umsetzung durchgeführt. Um den homogenen Verlauf der Reaktion sicherzustellen, ist durch Zusatz von geeigneten Lösungsvermittlern dafür zu sorgen, daß die Verseifungslösung während des ganzen Reaktionsablaufes homogen und einheitlich bleibt.

Die Verseifung der Carbonsäureestergruppen wird zweckmäßig bei Temperaturen von 20 bis 50°C durchgeführt. Höhere Temperaturen sind wegen der dabei möglichen, langsamen Hydrolyse der Urethangruppen, auch nach dem Verbrauch der Alkalihydroxyden durch die Carbonsäureestergruppen in Gegenwart von Wasser, zu vermeiden.

Die Isolierung der Photolacke erfolgt zweckmäßigerweise durch Ausfüllung des bei der Verseifung entstehenden Alkalisalzes mit einem Fällungsmittel. Die anschließende Reinigung erfolgt zweckmäßigerweise durch Umfällen des Polymerisates.

Der fertige Photolack löst sich gewöhnlich in stark polaren Lösungsmitteln, wie z. B. in Cyclohexanon, Äthylglykol, Methylglykol, Methanol, Äthanol, Propanol und Butanol bzw. in deren Gemischen.

Die Verwendbarkeit der Photolacke für die Reproduktionstechnik beruht auf ihrer Eigenschaft, nach Belichtung mit aktinischem Licht über die Doppelbindung der darin enthaltenen Cinnamoylgruppen infolge Dimerisation zu Vernetzen und dadurch in Lösungsmittel unlöslich zu werden, oder in Alkalien eine Löslichkeitsdifferenzierung zu erfahren. Als Lichtquellen können beliebige Lichtquellen, vorzugsweise aber solche, die einen hohen UV-Anteil besitzen, verwendet werden. Die Quantenausbeute des eingestrahlten Lichts und damit die Vernetzungsgeschwindigkeit kann mit einer großen Anzahl von Lichtsensibilisatoren in bekannter Weise verbessert bzw. beschleunigt werden.

Als solche können in Mengen von 0,01 bis 5 Gew.-% bezogen auf das Polymere, z. B. Verbindungen aus der Klasse der Aminobenzophenone, die Cyanine, der Triphenylmethanfarbstoff, Benzthiazoline, Benzanthrone, Chinone, Anthrochinone, aromatische Nitroverbindungen u. a. zugesetzt werden.

Die Lichtvernetzbarkeit der Photolacke wird durch das Molekulargewicht des Polymeren, durch den Gehalt desselben an lichtvernetzbaren Cinnamoylgruppen und durch die Menge und Wirksamkeit des zugesetzten Sensibilisators bestimmt und kann in weiten Grenzen variiert werden.

Gegenüber bekannten Systemen besitzen die Photolacke der Erfindung eine gute Dunkellagerstabilität sowohl als Flüssiglack als auch im beschichteten Zustand, die durch Zusatz von 0,01—5 Gew.-% Stabilisator bezogen auf Feststoff noch erheblich verbessert werden kann.

Geeignete Stabilisatoren sind z. B. 1-Anilinonaphthalin, 2-Anilinonaphthalin, 2,2-Bis-(4-hydroxyphenyl)-propan, Salizylsäurephenylester, 4-Methyl-2,6-di-tert.-butylphenol, o-Methylhydrochinon, Phenothiazin u. a.

Außer durch gute Lagerstabilität zeichnen sich die Photolacke der Erfindung durch hohe Elastizität und mechanische Widerstandsfähigkeit aus.

Besonders hervorzuheben ist die, durch die Möglichkeit mit schwachen wäßrig alkalischen Lösungen zu entwickeln, bedingte Umweltfreundlichkeit.

Die Photolacke der Erfindung eignen sich hervorragend zur Beschichtung von Buchdruck oder Offsetplatten von Druckwalzen oder Folien wie sie in der Reprotechnik verwendet werden. Auf Grund der hohen Elastizität und Resistenz gegenüber Säuren und Flankenschutzmittel, verliert z. B. eine mit dem Photolack der Erfindung beschichtete und mit Salpetersäure in einer Schnellätzmaschine tiefergelegte Zinkplatte kaum an Zeichnung, wodurch der Konturverlust äußerst gering ist.

Zur Erhöhung der Säurefestigkeit der belichteten und entwickelten Photolackschichten können wäßrige Nachbehandlungsbäder verwendet werden, die Metallsalze zwei oder mehrwertiger Kationen wie zum Beispiel $Zn^{2+}$, $Al^{3+}$, $Mg^{2+}$, $Ca^{2+}$, $Fe^{2+}$ oder $Fe^{3+}$ enthalten.

Selbstverständlich können die Photolacke der Erfindung auch zur Herstellung gedruckter Schaltungen, Skalen, Schildern, Formteile verwendet werden oder als Lacküberzüge, die durch nachfolgende Belichtung verbessert werden können.

Die Beschichtung kann durch Tauchen, Spritzen, Vorhanggießen, Schleudern oder elektrostatisch erfolgen. Auch ein thermischer Übertrag (Laminieren) von vorher beschichteten Trägern ist möglich.

Zur besseren Beurteilung hergestellter Kopien können dem Photolack solche Farbstoffe zugefügt werden, die im nahen UV-Bereich keine Eigenabsorbtion besitzen.

Um den jeweiligen Verarbeitungsbedingungen gerecht zu werden, ist es möglich, Zusätze wie

Verlaufmittel, Haftverbesserer, Weichmacher, Versprödungsmittel oder Füllstoffe zuzusetzen.

Die Herstellung der Polymeren der Erfindung wird durch die folgenden präparativen Beispiele 1 bis 8 erläutert. Die im folgenden verwendeten Prozentangaben sind, wenn nicht anders angegeben, Gewichtsprozent.

Polymer 1

83,3 g entsprechend 1 Mol trocknes, verseiftes Äthylen-Vinylacetat-Copolymerisat mit einem Hydroxylgruppengehalt von 20,4 Mol-% wurden bei 60°C in 800 g wasserfreiem Pyridin gelöst. Dann wurden innerhalb 60 Minuten 162,7 g entsprechend 0,75 Mol, 3-Isocyanatozimtsäureäthylester gelöst in 200 g wasserfreiem Pyridin eingetropft. Nach weiteren 30 Minuten wurden innerhalb 15 Minuten 58,1 g 2-Isocyanatoessigsäureäthylester, entsprechend 0,45 Mol, zugetropft und 2 Stunden bei 60° nachgerührt. Nach dieser Zeit war die Reaktion beendet. Die Heizung wurde entfernt und gleichzeitig 400 g Methanol zugesetzt. Bei Raumtemperatur von ca. 20—25°C wurde eine Lösung bestehend aus 67,2 g Kaliumhydroxid, entsprechend 1,2 Mol, 300 g Methanol und 500 g Wasser innerhalb 2 Stunden zugetropft und das Reaktionsgemisch über Nacht stehengelassen. Das gebildete Kaliumsalz wurde durch Zusatz von Aceton gefällt, das Fällungsmittel dekantiert, das Polymere in Wasser gelöst und mit Salzsäure die freie Carbonsäure ausgefällt. Der abgesaugte Polymerniederschlag wurde in ca. 2500 g Äthylglykol gelöst und diese Lösung durch Eindampfen unter vermindertem Druck auf 15 Gew.-% Feststoffkonzentration eingeengt und mit 1% Michlersketon, bezogen auf das Polymere sensibilisiert.

Polymer 2

39,15 g, entsprechend 0,5 Mol, trocknes verseiftes Äthylen-Vinylacetat-Copolymerisat mit einem Hydroxylgruppengehalt von 21,7 Mol-% wurden in 400 g Pyridin bei 100°C gelöst und innerhalb 2—3 Minuten 29,35 g Isocyanatoisophthalsäuredimethylester, entsprechend 0,125 Mol, in fester Form eingetragen. Nach 15 Minuten erhielt man eine Lösung. Es wurde nun 30 Minuten unter gleichzeitigem Senken der Temperatur auf 60°C gerührt und innerhalb 1 Stunde 73,8 g entsprechend 0,34 Mol 3-Isocyanatozimtsäureäthylester in 100 g Pyridin eingetropft. Nach 2 Stunden Rühren bei 60°C wurden 200 g Methanol zugesetzt. Danach wurde auf Raumtemperatur abgekühlt und innerhalb 1 Stunde eine Lösung aus 56 g, entsprechend 1 Mol Kaliumhydroxid, 100 g Wasser und 300 g Methanol zugetropft. Nach weiteren 3,5 Stunden Reaktionszeit wurde das gebildete K-Salz durch Fällen mit Aceton isoliert. Die Aufarbeitung geschah wie in Beispiel 1.

Polymer 3

19,5 g entsprechend 0,25 Mol-%, trockenes, verseiftes Äthylen-Vinylacetat-Copolymerisat mit einem Hydroxylgruppengehalt von 21,7% wurden in 200 ml trockenem Pyridin bei 60°C gelöst. Im weiteren wurde wie in Beispiel 1 verfahren mit dem Unterschied, daß nur 36,9 g entsprechend 0,17 Mol m-Isocyanatozimtsäureäthylester und kein Isocyanatessigsäureethylester eingesetzt wurden. Die Verseifung erfolgte mit 28 g entsprechend 0,5 Mol Kaliumhydroxid analog Beispiel 1.

Polymer 4

Beispiel 3 wurde wiederholt, mit dem Unterschied, daß statt 36,9 g Isocyanatozimtsäureäthylester 50,4 g entsprechend 0,23 Mol-%, eingesetzt wurden. Der so hergestellte Photolack wurde mit 1 Gew.-%, bezogen auf Polymeres, Michlersketon als Sensibilisator versetzt.

Polymer 5

19,5 g entsprechend 0,25 Mol, trocknes verseiftes Äthylen-Vinylacetat-Copolymerisat wurden in 200 g Pyridin mit 60°C gelöst. Innerhalb 1 Stunde wurden 26,9 g entsprechend 0,17 Mol, m-Isocyanatozimtsäureäthylester eingetropft und 60 Minuten nachgerührt. Bei 50°C wurden dann innerhalb 15 Minuten 10,77 g entsprechend 0,06 Mol, 3-Isocyanatopropionsäure-isobutylester eingetropft. Man rührt weitere 2 Stunden nach, gab 50 g Methanol zu und kühlte auf Raumtemperatur ab.

Die Verseifung erfolgte analog Beispiel 1, jedoch mit 28 g Kaliumhydroxyd entsprechend 0,5 Mol.

Polymer 6

124,5 g entsprechend 1,5 Mol trocknes, verseiftes Äthylen-Vinylacetat-Copolymerisat mit einem Hydroxylgruppengehalt von 20,4% wurden bei 60°C in 1200 g trockenem Pyridin gelöst. Innerhalb 1 Stunde wurde eine Lösung von 221,4 g m-Isocyanatozimtsäureäthylester, entsprechend 1,02 Mol, in 300 g Pyridin eingetropft, 30 Minuten nachgerührt, innerhalb 15 Minuten 48,9 g Isocyanatoessigsäureäthylester, entsprechend 0,370 Mol, zugetropft und 2 Stunden nachgerührt. Das Reaktionsgemisch wurde auf 25°C unter gleichzeitiger Zugabe von 600 g Methanol abgekühlt und anschließend eine Lösung aus 168 g Natriumhydroxid, entsprechend 4,2 Mol 300 g Wasser und 900 g Methanol innerhalb 60 Minuten eingetropft. Nach weiteren 3,5 Stunden war die Reaktion beendet. Das gebildete Natriumsalz wurde durch Fällen mit Aceton isoliert und mit Salzsäure in die entsprechende Carbonsäure überführt. Das Polymere wurde wie in Beispiel 1 beschrieben, in eine 15 gewichtsprozentige Lösung in Cyclohexanon überführt, mit 1,5% Sensibilisator (Michlers-Keton) sensibilisiert und mit 1% Stabilisator (Di-tert.-p-butyl-Kresol) stabilisiert.

Polymer 7

Es wurde in gleicher Weise wie in Beispiel 6 verfahren, nur statt Isocyanatoessigsäureester wurden 71,6 g entsprechend 0,375 Mol Isocyanatobenzoesäureäthylester eingesetzt.

Polymer 8

10 g Polyvinylalkohol (Moviol [R] N 70/88 Hersteller Hoechst AG) werden in 100 ml Pyridin bei 60°C gelöst. Unter vermindertem Druck wurden bei 60°C 20 ml Pyridin abdestilliert und bei dieser Temperatur 8,4 g Benzoylchlorid (dest.) zugetropft. Dann wurde 1 Stunde nachgerührt und innerhalb 30 Minuten eine Lösung bestehend aus 28,8 g Isocyanatozimtsäureäthylester in 100 g Pyridin gelöst eingetropft. Nun wurde abermals 3 Stunden bei 60°C nachgerührt und das hierbei ausfallende Polymere durch Zugabe von 250 ml Pyridin wieder gelöst und dann auf Raumtemperatur abgekühlt. Es wurde nun eine Lösung aus 20 g Natriumhydroxid in 300 g Wasser bei Raumtemperatur eingetropft, wodurch die Estergruppen verseift wurden. Durch Zugabe von 2 l Aceton wurde das Polymere ausgefällt. Das vom Fällungsmittel abgetrennte Polymere wurde in 1 l Wasser gelöst und mit 10%iger Salzsäure auf pH 3 angesäuert. Der sich hierbei bildende Niederschlag wurde abgesaugt, mehrmals mit Wasser gewaschen und in 1,5 l Äthylglykol aufgenommen. Unter vermindertem Druck bei 50°C wurde dann soweit abdestilliert, bis ein Gesamtvolumen von ca. 700 ml im Kolben verblieb. Der Feststoffgehalt betrug 20%. Der so hergestellte Photolack wurde mit 1% Michlers-Keton sensibilisiert und mit 1,5% 2,6-Di-tert.-butyl-p-Kresol (berechnet auf Feststoff) stabilisiert. Zur besseren Sichtbarmachung wurde der Lack mit 1- Astrazonblau (berechnet auf Lösung) eingefärbt.

Beispiele

Es werden die Polymeren 1 bis 8 der Erfindung mit den bekannten Polymeren A und B verglichen.

Das Polymere A wurde wie in Beispiel 1 der DE-OS 2 111 415 beschrieben hergestellt und entspricht etwa folgender Formel:

A. 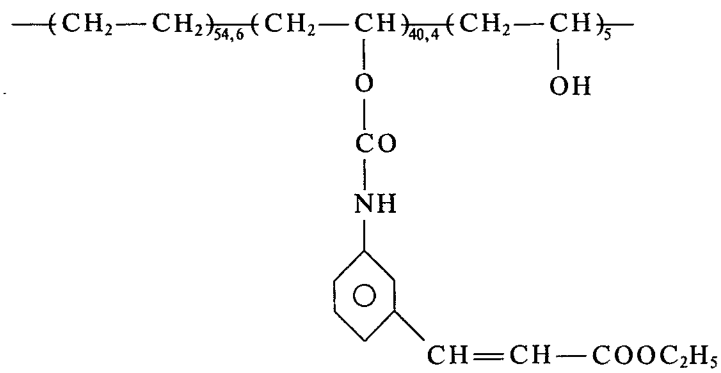

Das Polymere B entspricht der Probe 3 aus Beispiel 1 der DE-AS 1 080 403 und hat etwa folgende Formel

B. 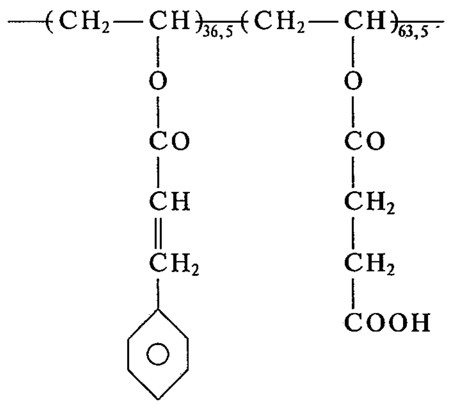

Die Prüfung der Polymeren 1 bis 8 und der Vergleichsphotolacke A und B wurde wie folgt durchgeführt:

10 Zinkplatten wurden jeweils mit einem der Polymeren 1 bis 8 sowie A und B beschichtet. Die Schichtdicken betrugen 3 µm.

Die einzelnen Proben wurden dann mit einer 1200 W Kohlenbogenlampe als UV-Lichtquelle 3 Minuten lang aus einem Abstand von 40 cm durch einen Stufenkeil mit der Konstanten 0,15 belichtet.

Anschließend wurden die Proben 3 Minuten lang bei Raumtemperatur mit 0,05%iger Natronlauge entwickelt. Das entwickelte Bild des Stufenkeils liefert ein Maß für die Lichtempfindlichkeit des Polymeren.

Die Lagerstabilität der Proben wurde durch Lagerung in einem Heizschrank bei 120°C über verschiedene Zeiten getestet. Die Proben wurden dazu einer Zeitskala entsprechend dem Heizschrank entnommen und in der beschriebenen Weise belichtet und entwickelt. Ab einer bestimmten Lagerzeit ist die Entwicklung einer Probe, d. h. das Ablösen der unbelichteten Schichtteile nicht mehr möglich.

Die Qualität der Haftung des Photolacks auf der Zinkplatte wird wie folgt geprüft:

Die Beschichtung der Probe geschieht durch einen 54er Punktraster in der vorher beschriebenen Weise. Nach der ebenfalls wie beschrieben durchgeführten Entwicklung und Ätzung der Probe werden die 5%igen Rasterpunkte unter dem Mikroskop beurteilt. Bei sehr guter Haftung (Benotung 1) sind alle Rasterpunkte kreisförmig und mit einer Photolackschicht bedeckt. Bei sehr schlechter Haftung (Benotung 5) sind nur noch 80% der Rasterpunkte mit einer Photolackschicht bedeckt und 20% durch das Ätzmittel zerstört worden. Gute Haftung (Benotung 2) bedeutet dementsprechend, daß etwa 90% der Rasterpunkte in kreisrunder Form erhalten geblieben sind während etwa 10% von dieser Kreisform abweichen, d. h. es hat eine partielle Ablösung des Photolackes stattgefunden.

Die Ergebnisse der Prüfung der Photolackschichten sind in der folgenden Tabelle zusammengestellt.

| Polymer | Entwicklungszeit in Minuten | Lichtempfindlichkeit | Lagerstabilität bei 120 C (Stunden) | Beurteilung der Haftung |
|---|---|---|---|---|
| 1 | 1,5 | 10 | 5 | 1 |
| 2 | 1,5 | 9 | 4 | 2 |
| 3 | 1,5 | 10 | 5 | 1 |
| 4 | 1,5 | 9 | 4 | 2 |
| 5 | 1,5 | 9 | 4 | 2 |
| 6 | 1,5 | 10 | 5 | 1 |
| 7 | 1,5 | 10 | 5 | 1 |
| 8 | 1,5 | 9 | 3 | 2 |
| A | nicht entwickelbar*) | 10*) | 5*) | 1*) |
| B | 3 | 6 | 0,5 | 5 |

*) Ergebnis erhalten nach Entwicklung mit Butylacetat/Äthylacetat 1 : 1

**Patentansprüche**

1. Lichtempfindliche Schicht aus einem filmbildenden, unter Lichteinwirkung vernetzbaren, in wäßrig alkalischer Lösung entwickelbaren, Cinnamoylgruppen enthaltenden Polymeren, dadurch gekennzeichnet, daß das Polymere der allgemeinen Formel

$$-(CH_2-CH_2)_u-(A)_v-$$

entspricht, in der

u 0 bis 70 Mol-%
v 30 bis 100 Mol-% und

A 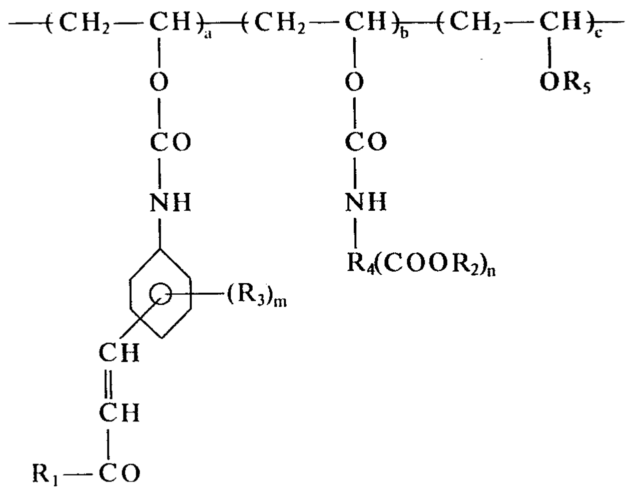

bedeuten und worin

$R_1$ Hydroxyl, Alkyl mit 1 bis 4 Kohlenstoffatomen, Aryl oder Alkoxy mit 1 bis 4 Kohlenstoffatomen, wobei die für $R_1$ enthaltenen Gruppen gleich oder verschieden sein können und der Anteil an Hydroxylgruppen mindestens 30 Mol-% beträgt,

$R_2$ ein Wasserstoffatom oder Alkyl mit 1 bis 4 Kohlenstoffatomen, wobei die für $R_2$ enthaltenen Reste

gleich oder verschieden sein können und der Anteil an Wasserstoffatomen mindestens 30 Mol-% beträgt,

$R_3$ ein Halogenatom, eine $NO_2$-Gruppe, eine $CF_3$-Gruppe, Alkyl mit 1 bis 4 Kohlenstoffatomen oder Alkoxy mit 1 bis 4 Kohlenstoffatomen,

$R_4$ Alkylen mit 1 bis 6 Kohlenstoffatomen oder Arylen,

$R_5$ ein Wasserstoffatom, wenn $u>0$ und ein Wasserstoffatom, eine $CH_3CO$-Gruppe oder eine $C_6H_5CO$-Gruppe, wenn $u=0$

m 0 bis 3

n 1 bis 3

a 20 bis 100 Mol-%

b 0 bis 50 Mol-%

c 0 bis 30 Mol-%

2. Lichtempfindliche Schicht nach Anspruch 1, dadurch gekennzeichnet, daß sie ein Polymeres der Formel

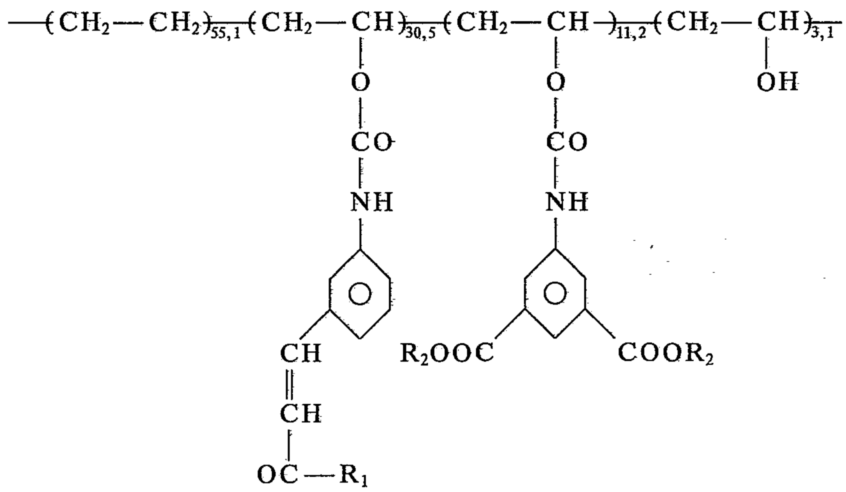

enthält, worin

$R_1$ für 62 Mol-% OH und 38 Mol-% $OC_2H_5$

$R_2$ für 62 Mol-% H und 38 Mol-% $CH_3$

steht.

3. Lichtempfindliche Schicht nach Anspruch 1, dadurch gekennzeichnet, daß sie ein Polymeres der Formel

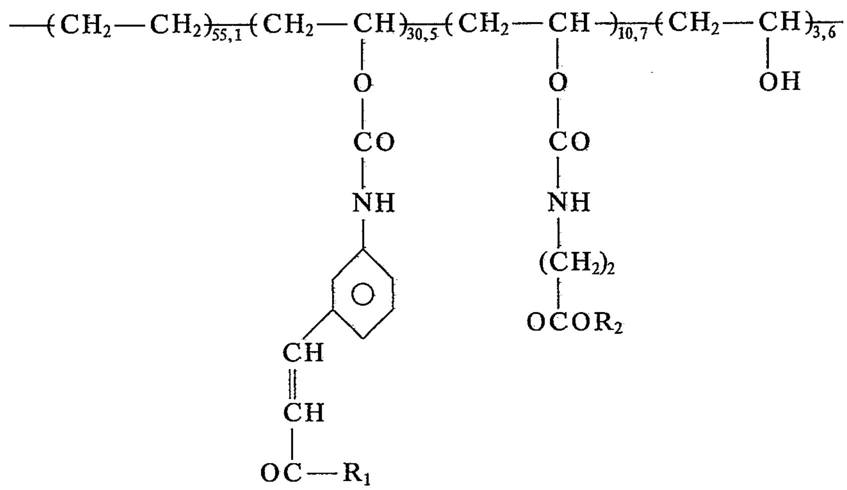

enthält, worin

$R_1$ für 96 Mol-% OH und 4 Mol-% $CO_2H_5$

$R_2$ für 96 Mol-% H und 4 Mol-% iso$C_4H_9$

steht.

4. Lichtempfindliche Schicht nach Anspruch 1, dadurch gekennzeichnet, daß sie eine Polymeres der Formel

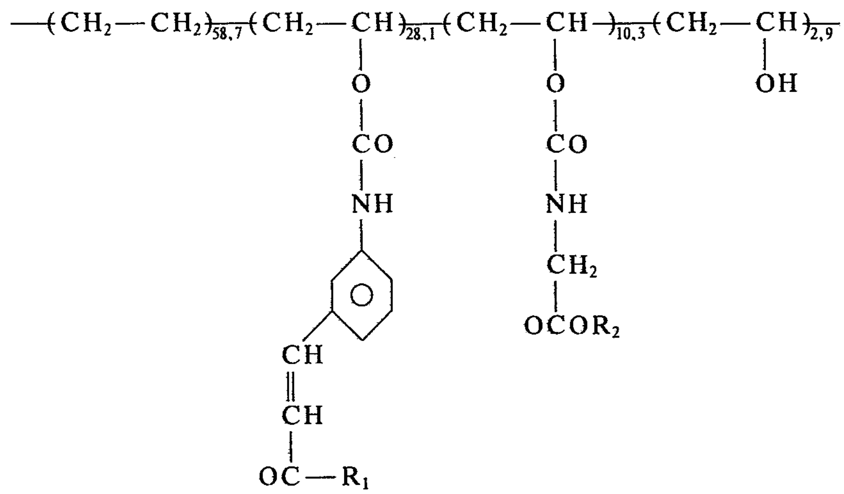

enthält, worin

$R_1$ für 98 Mol-% OH und 2 Mol-% $OC_2H_5$
$R_2$ für 98 Mol-% H und 2 Mol-% $C_2H_5$

steht.

## Claims

1. Photo-sensitive layer comprising a film-forming polymer which is crosslonkable under the effect of light, can be developed in an aqueous alkaline solution, and contains cinnamoyl groups, characterised in that the polymer corresponds to the general formula

$$-(CH_2-CH_2)_u-(A)_v-$$

in which

u denotes 0 to 70 mol%
v denotes 30 to 100 mol% and
A denotes

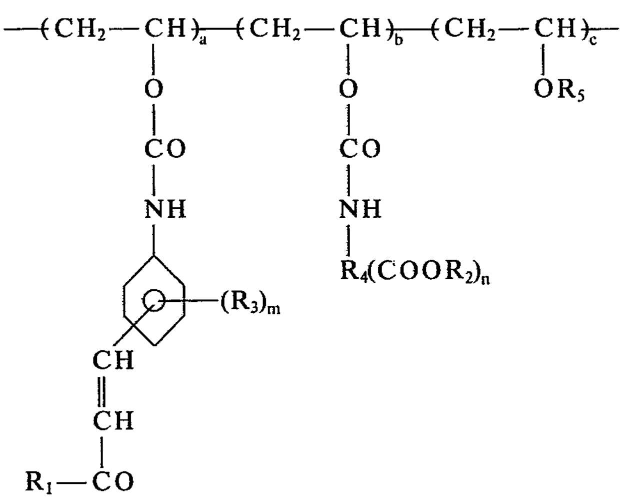

and wherein

$R_1$ denotes hydroxyl, alkyl with 1 to 4 carbon atoms, aryl or alkoxy with 1 to 4 carbon atoms, and the groups representing $R_1$ contained in the polymer can be identical or different and the content of

hydroxyl groups amounts to at least 30 mol%,

$R_2$ denotes a hydrogen atom or alkyl with 1 to 4 carbon atoms, and the radicals representing $R_2$ contained in the polymer can be identical or different and the amount of hydrogen atoms amounts to at least 30 mol%,

$R_3$ denotes a halogen atom, an $NO_2$ group, a $CF_3$ group, alkyl with 1 to 4 carbon atoms or alkoxy with 1 to 4 carbon atoms,

$R_4$ denotes alkylene with 1 to 6 carbon atoms or arylene,

$R_5$ denotes a hydrogen atom when $u > 0$ and a hydrogen atom, a $CH_3CO$ group or a $C_6H_5CO$ group when $u = 0$,

m denotes 0 to 3

n denotes 1 to 3

a denotes 20 to 100 mol%

b denotes 0 to 50 mol%

c denotes 0 to 30 mol%.

2. Photo-sensitive layer according to Claim 1, characeterised in that it contains a polymer of the formula

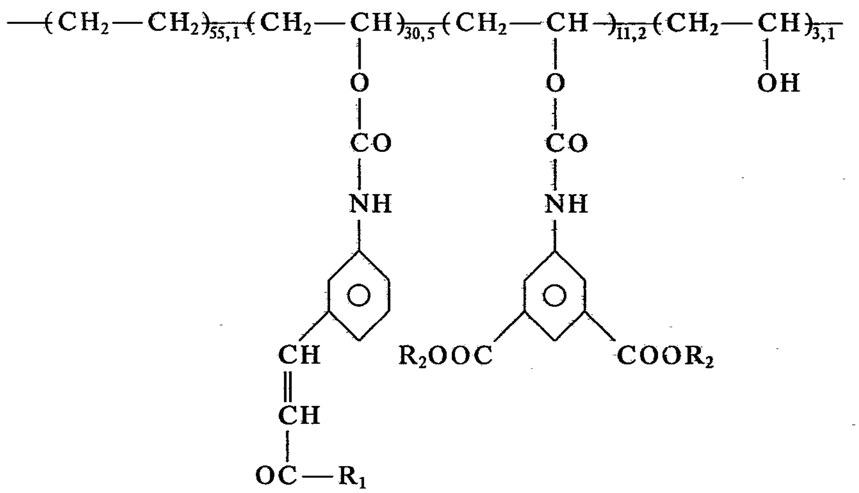

wherein

$R_1$ represents 62 mol% of OH and 38 mol% of $OC_2H_5$ and

$R_2$ represents 62 mol% of H and 38 mol% of $CH_3$.

3. Photo-sensitive layer according to Claim 1, characeterised in that it contains a polymer of the formula

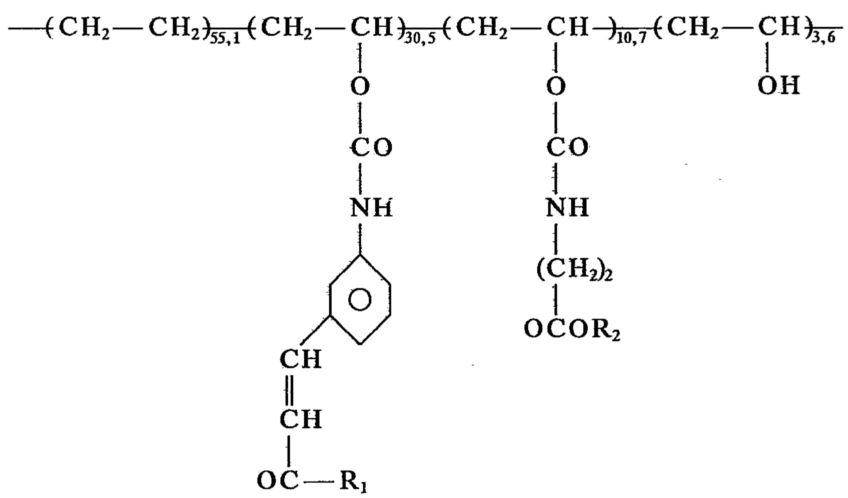

wherein

$R_1$ represents 96 mol% of OH and 4 mol% of $OC_2H_5$ and

$R_2$ represents 96 mol% of H and 4 mol% of iso$C_4H_9$.

4. Light-sensitive layer according to Claim 1, characterised in that it contains a polymer of the formula

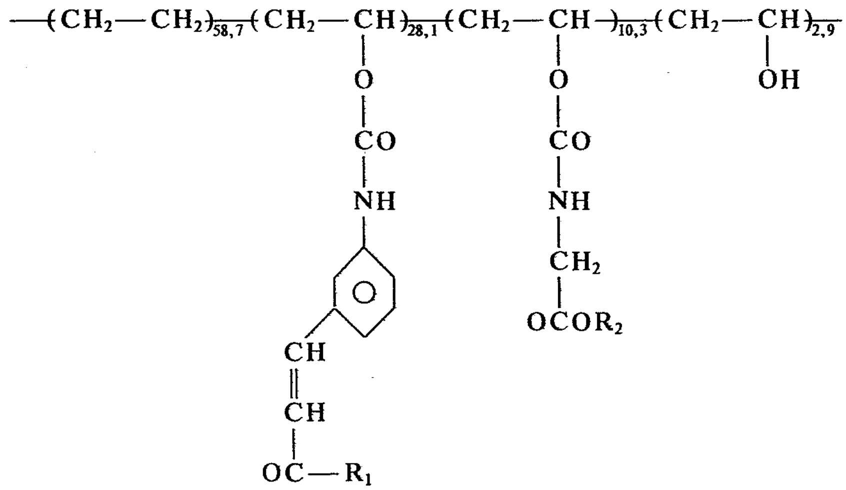

wherein

$R_1$ represents 98 mol% of OH and 2 mol% of $OC_2H_5$ and
$R_2$ represents 98 mol% of H and 2 mol% of $C_2H_5$.

**Revendications**

1. Couche photosensible consistant en un polymère filmogène à groupes cinnamoyle, développable en solution alcaline aqueuse, réticulable sous l'action de la lumière caractérisée en ce que le polymère correspond à formule générale

$$-(CH_2-CH_2)_u-(A)_v-$$

dans laquelle

u représente 0 à 70 moles%,
v représente 30 à 100 moles%, et A représente

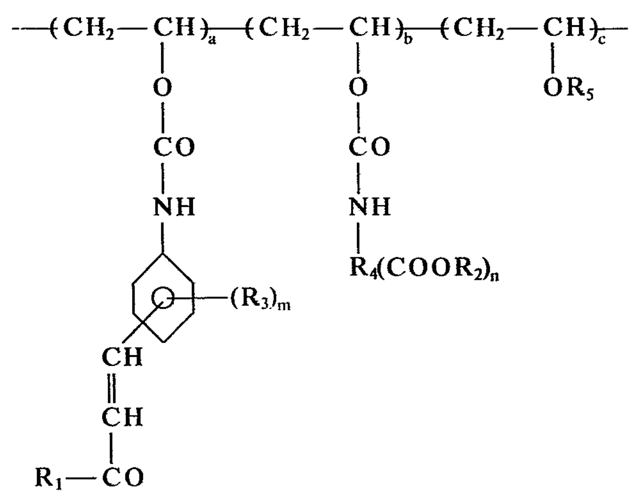

et où

$R_1$ représente un groupe hydroxyle, alkyle en $C_1-C_4$, aryle tel que phényle et naphtyle ou alcoxy en $C_1-C_4$, les groupes contenus pour $R_1$ nodvant être identiques ou différents et la fraction de groupes hydroxyle étant d'au moins 30 moles%,
$R_2$ représente un atome d'hydrogène ou un groupe alkyle en $C_1-C_4$, les restes contenus pour $R_2$ pouvant être identiques ou différents et la fraction d'atomes d'hydrogène étant d'au moins 30 moles%,

$R_3$ représente un atome d'halogène, un groupe $NO_2$, un groupe $CF_3$, un groupe alkyle en $C_1-C_4$ ou alcoxy en $C_1-C_4$,
$R_4$ représente un groupe alkylène en $C_1-C_6$ ou arylène,
$R_5$ représente un atome d'hydrogène lorsque $u>0$ et un atome d'hydrogène, un groupe $CH_3CO$- ou un grouppe $C_6H_5CO$- lorsque $u=0$,
m est égal à 0 à 3,
n est égal à 1 à 3,
a représente 20 à 100 moles%,
b représente 0 à 50 moles%,
c est égal à 0 à 30 moles%.

2. Couche photosensible selon la revendication 1, caractérisée en ce qu'elle contient un polymère de formule

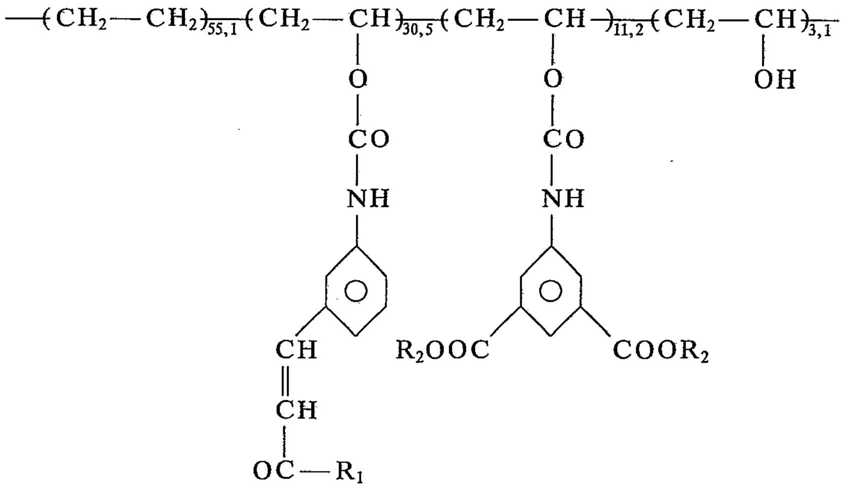

dans laquelle

$R_1$ représente 62 moles% de groupes OH et 38 moles% de groupes $OC_2H_5$
$R_2$ représente 62 moles% d'atomes H et 38 moles% de groupes $CH_3$

3. Couche photosensible selon la revendication 1, caractérisée en ce qu'elle contient un polymère de formule

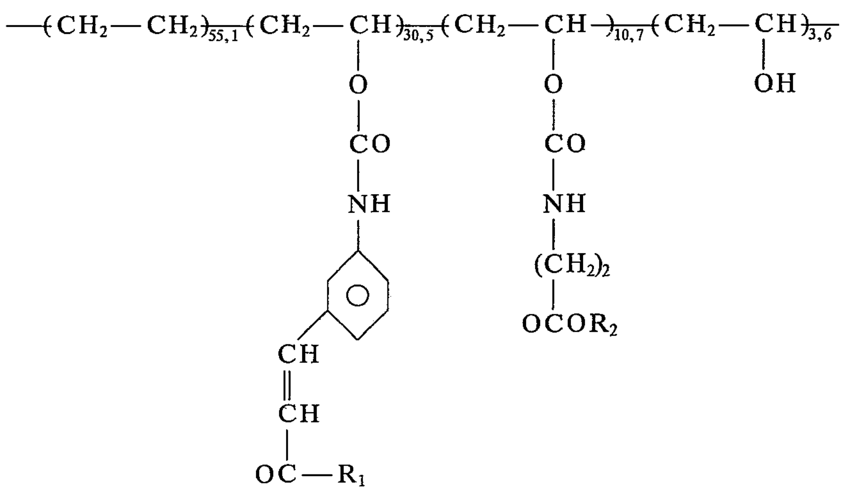

dans laquelle

$R_1$ représente 96 moles% de groupes OH et 4 moles% de groupes $OC_2H_5$
$R_2$ représente 96 moles% d'atomes H et 4 moles% de groupes $isoC_4H_9$

4. Couche photosensible selon la revendication 1, caractérisée en ce qu'elle contient un polymère de formule

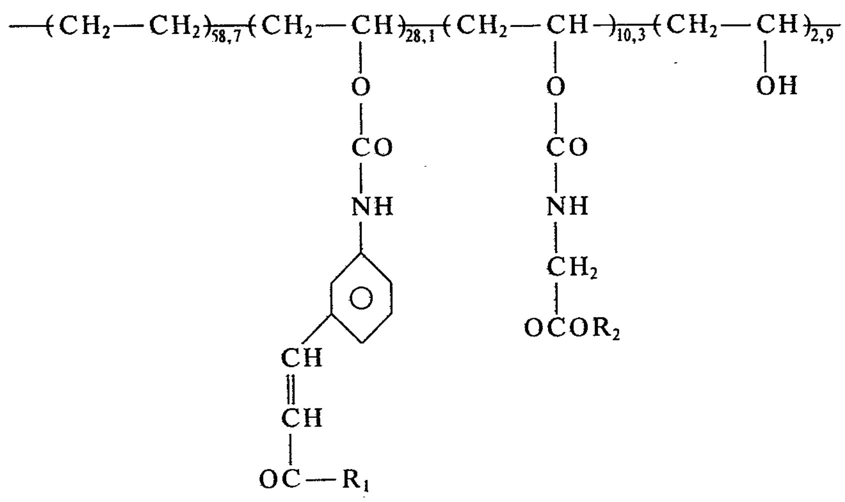

dans laquelle

$R_1$ représente 98 moles% de groupes OH et 2 moles% de groupes $OC_2H_5$
$R_2$ représente 98 moles% d'atomes H et 2 moles% de groupes $C_2H_5$.